# EUROPEAN PATENT APPLICATION

(11) **EP 0 720 380 A2**
(43) Date of publication of application: **03.07.1996**
(21) Application number: 95309461.2
(22) Date of filing: 27.12.1995
(51) Int. Cl.: H04N 7/26

(54) **Start code detecting apparatus for bit stream of compressed image**

(30) Priority: 30.12.1994 KR 9440133
(71) Applicant: Samsung Electronics Co., Ltd., Suwon-city, Kyungki-do 441-370 (KR)
(72) Inventor: Jung, Jun-mo, Suwon-city, Kyungki-do (KR)
(74) Representative: Chugg, David John

(57) **Abstract**

A start code detecting apparatus for detecting a start code which indicates the start position of each layer from the bit stream of a compressed image according to the MPEG-standard is provided. The start code detecting apparatus includes two registers (10, 12), a barrel shifter (14), a start code detector (16), a state machine (18), a code length generator (20) and an accumulator (22). Therefore, the start code detecting apparatus adopts the barrel shifter (14) and the start code detector (16), so that the start code designating the start position of each layer can be effectively detected from the compressed bit stream.

## Description

The present invention relates to a start code detecting apparatus for detecting a start code, such as a start code which indicates the start position of each layer from the bit stream of a compressed image according to the standard suggested by the Moving Picture Experts Group (MPEG).

A video sequence according to the MPEG-2 standard is comprised of a sequence header, one or more picture groups following the sequence header, and a sequence end code. A compressed bit stream should have a syntax. Here, the syntax is comprised of six layers for supporting each signal process of system function.

Table 1 shows each syntax layer and the functions corresponding to each syntax layer.

**Table 1**

| syntax layer | function |
|---|---|
| sequence layer | random access unit |
| picture group layer | random access unit |
| picture layer | basic coding unit |
| slice layer | resynchronizing unit |
| macro block layer | motion compensating unit |
| block layer | DCT unit |

An MPEG-2 decoder should recognize the start position of each layer so as to correctly decode the compressed bit stream. In the MPEG-2 stream, each layer is classified by a specific code which is called a start code. The start code is a reserved code which should not occur at any other place of the bit stream.

Table 2 shows the start codes of each layer.

**Table 2**

| syntax layer | value |
|---|---|
| sequence layer | 000001B3h |
| picture group layer | 000001B8h |
| picture layer | 00000100h |
| slice layer | 00000101h |
| macro block layer | 00000111h |

It is an aim of preferred embodiments of the present invention to provide a start code detecting apparatus for detecting a start code which indicates the start position of each syntax layer from a bit stream of a compressed image.

According to a first aspect of the invention, there is provided a start code detecting apparatus for detecting a start code which indicates the start position of each layer from the bit stream of a compressed image according to MPEG-2 standard, comprising: two registers connected in series for converting an input bit stream into parallel data of a predetermined latched bit number (N), for shifting the stored bit rows in response to a carry signal and for outputting the shifted bit rows; a barrel shifter for receiving the parallel data latched by the two registers and outputting a successive bit row of a predetermined bit number (M), wherein the bit row follows from a position designated by a shift signal applied to the barrel shifter; a start code detector for storing the start code of each layer in the compressed bit stream as an input entry, detecting whether the output bit rows of the barrel shifter match the input entry, and outputting the matched start code; a state machine for storing the start code of each layer and a state code corresponding to the start code as an input entry, and outputting the state code corresponding to the start code output from the start code detector; a code length generator for storing the state code of each layer and the bit number corresponding to each state code as an input entry, and outputting the bit number corresponding to the state code output from the state machine; and an accumulator for accumulating the outputs of the code length generator and applying the accumulated value as a shift signal of the barrel shifter and a carry as a carry signal of the registers, respectively.

According to a second aspect of the invention, there is provided an apparatus for detecting start codes indicating the start positions of variable bit length data sequences within a compressed bit stream, the apparatus comprising:
serial to parallel converting means for receiving the compressed bit stream and latching the bit stream to provide a parallel data output;
barrel shifting means for receiving the parallel data output from the serial to parallel converting means, shifting the received data and providing an M-bit parallel output;
recognising means connected to the output of the barrel shifting means and arranged to compare the M-bit input data to prestored start codes, the recognising means being arranged upon coincidence of the M-bit data with any of said prestored start codes to recognise the start points of said data sequences;
data sequence retrieval means connected to the output of said barrel shifting means, the data sequence retrieval means being arranged to reconstruct said data sequences in accordance with said recognised start points; and
control means arranged in accordance with particular recognised start codes to control latching of the serial to parallel converting means and shifting of the barrel shifting means.

Preferably, said serial to parallel converting means comprises two registers connected in series for converting the compressed bit stream into said parallel data output, each of said registers having N-bits to form a 2N-bit output being arranged to be shifted in response to a carry signal generated by said control means.

Preferably said barrel shifting means comprises a barrel shifter arranged to receive the parallel data output from the serial to parallel converting means, and to shift data in accordance with a shift signal generated by the control means.

Preferably, said recognising means comprises a start code detector and a state machine, the start code detector being arranged to store said prestored start codes and to receive outputs from said barrel shifting means and, when a start code is recognised, outputting the start code to said state machine.

Preferably, the state machine is arranged to receive the start code from the start code detector and, in dependence upon said start code, determining what parameters will be following said start code, the state machine being arranged to generate an output which partitions the output from the barrel shifting means so as to enable storage of said variable bit length data sequences within said data sequence retrieval means.

Preferably, said control means comprises a code length generator which receives an output from the recognising means and an accumulator connected to the output of said code length generator and arranged to generate shift signals for said barrel shifter and carry signals for controlling said serial to parallel converting means.

For a better understanding of the invention, and to show how embodiments of the same may be carried into effect, reference will now be made, by way of example, to the accompanying diagrammatic drawings, in which:
Figure 1 is a block diagram showing the structure of a start code detecting apparatus according to an embodiment of the present invention; and
Figure 2 is a diagram for illustrating the operation of the barrel shifter shown in Figure 1.

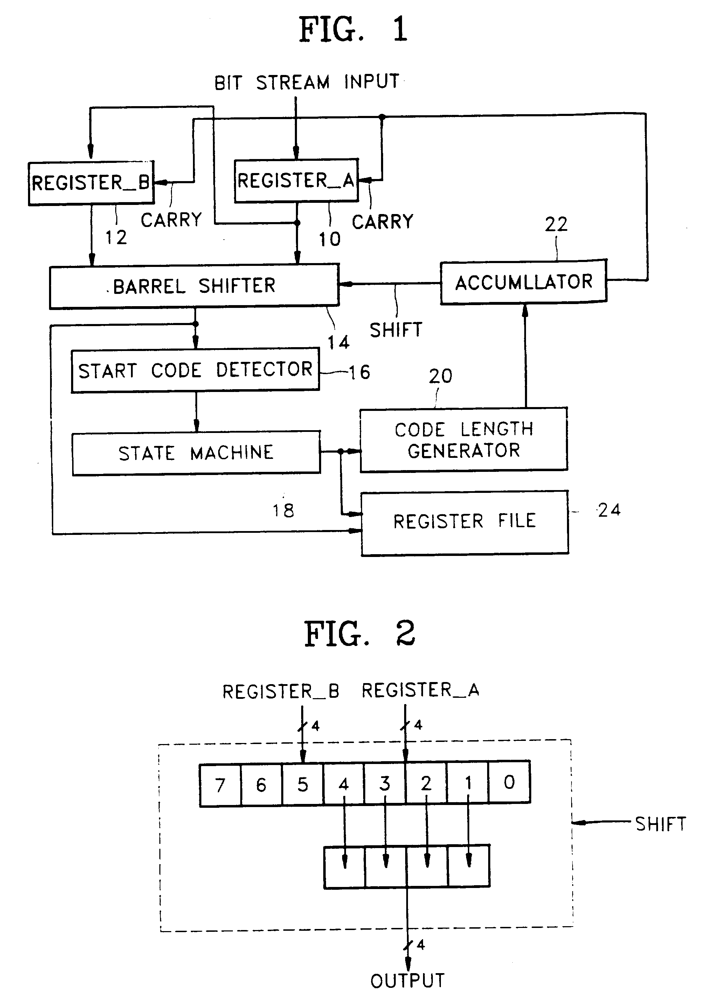

In Figure 1 showing a start code detecting apparatus according to an embodiment of the present invention, reference numerals 10 and 12 denote a register_A and a register_B, respectively of a serial to parallel converting means, a reference numeral 14 denotes a barrel shifting means in the form of a barrel shifter, a reference numeral 16 and 18 denote a start code detector and state machine respectively of a recognising means, a reference numeral 20 and 22 denote a code length generator and an accumulator respectively of a control means, and a reference numeral 24 denotes a data sequence retrieval means in the form of a register file.

Register_A 10 and register_B 12 are connected to each other in series. Register_A 10 latches the compressed bit stream every N bits and register_B 12 latches the bit stream output from register_A 10. Register_A 10 and register_B 12 shift the bit rows latched in response to a carry signal applied thereto and then output the shifted bit rows. As the shifted bit rows latched by each register are output, the first N bits of the compressed bit stream is input to register_A 10 in sequence, and the shifted bit rows output from register_A 10 are sequentially input to register_B 12 and then latched. The bit rows latched by register_A 10 and register_B 12 are applied to barrel shifter 14, as N-bit parallel data.

Barrel shifter 14 receives N-bit parallel data output from register_A 10 and register_B 12 and each input thereof is sequentially aligned to form 2N-bit parallel data. Barrel shifter 14 outputs M-bit parallel data among the 2N-bit parallel data in response to a shift signal applied thereto, wherein the M-bit parallel data follows in sequence from a position designated by the shifted signal.

Figure 2 is a diagram illustrating the operation of barrel shifter 14 shown in Figure 1. As well known, when barrel shifter 14 outputs the data, the bit position of the data is shifted according to the value of the shift signal applied thereto. For example, as shown in Figure 2, supposing that 8-bit data is input, 4-bit data is output and the value of the shift signal is three, the fourth to seventh bit rows are output among 8-bit parallel data.

Start code detector 16 detects whether the bit rows output from barrel shifter 14 include the start codes of each layer of the MPEG-2 compressed bit stream and outputs the corresponding start code. Start code detector 16 respectively stores the various start codes as an input entry. it is then determined whether the stored input entries match the parallel data output from barrel shifter 14, and if a start code matching the parallel data is detected, the detected start code is provided to state machine 18.

Here, the start code is a reference for sectioning the bit stream. That is, the bit number of the respective parameters following the start code is varied according to the content of the start code. For example, a start code is followed by parameters such as a 4-bit parameter, a 2-bit parameter and 3-bit parameter, while another start code is followed by parameters such as a 3-bit parameter, a 5-bit parameter and 1-bit parameter. Thus, if a start code is detected, the number of parameters following the start code and the bit number of each parameter can be obtained.

State machine 18 outputs the state codes corresponding to the bit number of each successive parameter following the start code provided from start code detector 16.

As described above, the number of parameters following the start code and the bit number of each parameter varies according to the start code. The state codes output from state machine 18 represent the bit number of each parameter. For example, if there are three successive parameters following a start code, each being comprised of four bits, two bits and three bits, respectively, the number of th estate codes corresponding to each start code is three (state #1, state #2 and state #3), the values of each state code being 4, 2 and 3, respectively.

Register file 24 takes the data corresponding to the bit number designated by the state code provided from state machine 18, among the parallel data output from barrel shifter 14, and stores the taken parallel data in register file 24. For example, when the state codes are state #1, state #2 and state #3, a 4-bit register, 2-bit register and 3-bit register are required.

Code length generator 20 decodes the bit number corresponding to the state code output from state machine 18 and provides the result to accumulator 22. Accumulator 22 sums the previously accumulated value and the bit number output from code length generator 20 and provides the result to the shift terminal of barrel shifter 14. Barrel shifter 14 outputs the parallel data shifted by the shift signal applied thereto.

The carry generated from accumulator 22 is provided as the carry signal of register_A 10 and register_B 12. When the carry signal is applied, register_A 10 and register_B 12 shift the stored bit rows, by outputting the shifted bit rows and latching new input bit rows.

As described above, the start code detecting apparatus according to the present invention adopts a barrel shifter and a start code detector, so that the start code representing the start position of each syntax layer can be effectively detected from the bit stream of the compressed image according to the MPEG standard.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A start code detecting apparatus for detecting a start code which indicates the start position of each layer from the bit stream of a compressed image according to MPEG-2 standard, comprising:
two registers (10, 12) connected in series for converting an input bit stream into parallel data of a predetermined latched bit number (N), for shifting the stored bit rows in response to a carry signal and for outputting the shifted bit rows;
a barrel shifter (14) for receiving the parallel data latched by said two registers (10, 12) and outputting a successive bit row of a predetermined bit number (M), wherein the bit row follows from a position designated by a shift signal applied to said barrel shifter (14);
a start code detector (16) for storing the start code of each layer in the compressed bit stream as an input entry, detecting whether the output bit rows of said barrel shifter (14) match the input entry, and outputting the matched start code;
a state machine (18) for storing the start code of each layer and a state code corresponding to the start code as an input entry, and outputting the state code corresponding to the start code output from said start code detector (16);
a code length generator (20) for storing the state code of each layer and the bit number corresponding to each state code as an input entry, and outputting the bit number corresponding to the state code output from said state machine; and
an accumulator (22) for accumulating the outputs of said code length generator (20) and applying the accumulated value as a shift signal of said barrel shifter (14) and a carry as a carry signal of said registers (10, 12), respectively.

2. Apparatus for detecting start codes indicating the start positions of variable bit length data sequences within a compressed bit stream, the apparatus comprising:
serial to parallel converting means (10, 12) for receiving the compressed bit stream and latching the bit stream to provide a parallel data output;
barrel shifting means (14) for receiving the parallel data output from the serial to parallel converting means, shifting the received data and providing an M-bit parallel output;
recognising means (16, 18) connected to the output of the barrel shifting means and arranged to compare the M-bit input data to prestored start codes, the recognising means being arranged upon coincidence of the M-bit data with any of said prestored start codes to recognise the start points of said data sequences;
data sequence retrieval means (24) connected to the output of said barrel shifting means, the data sequence retrieval means being arranged to reconstruct said data sequences in accordance with said recognised start points; and
control means (20, 22) arranged in accordance with particular recognised start codes to control latching of the serial to parallel converting means and shifting of the barrel shifting means.

3. Apparatus according to claim 2, wherein said serial to parallel converting means comprises two registers (10, 12) connected in series for converting the compressed bit stream into said parallel data output, each of said registers (10, 12) having N-bits to form a 2N-bit output being arranged to be shifted in response to a carry signal generated by said control means (20, 22).

4. Apparatus according to claim 2 or 3, wherein said barrel shifting means comprises a barrel shifter (14) arranged to receive the parallel data output from the serial to parallel converting means, and to shift data in accordance with a shift signal generated by the control means (20, 22).

5. Apparatus according to claims 2, 3 or 4, wherein said recognising means comprises a start code detector (16) and a state machine (18), the start code detector (16) being arranged to store said prestored start codes and to receive outputs from said barrel shifting means and, when a start code is recognised, outputting the start code to said state machine (18).

6. Apparatus according to claim 5, wherein the state machine (18) is arranged to receive the start code from the start code detector (16) and, in dependence upon said start code, determining what parameters will be following said start code, the state machine (18) being arranged to generate an output which partitions the output from the barrel shifting means so as to enable storage of said variable bit length data sequences within said data sequence retrieval means (24).

7. Apparatus according to any of claims 2 to 6, wherein said control means comprises a code length generator (20) which receives an output from the recognising means and an accumulator (22) connected to the output of said code length generator (20) and arranged to generate shift signals for said barrel shifter and carry signals for controlling said serial to parallel converting means (10, 12).
